# FASCICULE DE BREVET EUROPEEN

(11) **EP 4 526 691 B1**
(45) Date de publication et mention de la délivrance du brevet: **01.07.2026**
(21) Numéro de dépôt: 23727950.0
(22) Date de dépôt: 16.05.2023
(51) Int. Cl.: G01R 29/08

(54) **BRASSEUR DE CHAMP ELECTROMAGNETIQUE POUR ENCEINTE DE TEST CEM**
ELEKTROMAGNETFELDRÜHRER FÜR EIN EMV-TESTGEHÄUSE
ELECTROMAGNETIC FIELD STIRRER FOR AN EMC TEST ENCLOSURE

(30) Priorité: 16.05.2022 FR 2204601
(43) Date de publication de la demande: 26.03.2025
(73) Titulaire: COMPAGNIE GENERALE DES ETABLISSEMENTS MICHELIN, 63000 Clermont-Ferrand (FR)
(72) Inventeur: VOLLET, Ludovic, 63040 CLERMONT-FERRAND CEDEX 09 (FR); MANGIN, Lise, 63040 CLERMONT-FERRAND CEDEX 09 (FR)
(74) Mandataire: M.F.P. Michelin
(86) Numéro de dépôt international: PCT/EP2023/063073
(87) Numéro de publication internationale: WO 2023/222661

(56) Documents cités:
- DE-A1- 102006 056 998
- DE-A1- 102017 006 972
- US-A1- 2019 339 315
- US-A1- 2020 132 719

## Description

La présente invention se rapporte au domaine des enceintes de test de la compatibilité électromagnétique des équipements électroniques des appareils ou des équipements de l'aérospatial, de l'aéronautique de l'automobile ou du civil. Ces enceintes de test sont également connues sous le nom d'enceintes faradisées. L'invention concerne plus particulièrement un dispositif de brassage mécanique des ondes électromagnétiques dans une telle enceinte de test.

Une enceinte de test de la compatibilité électromagnétique (CEM ou ECM de « ElectroMagnetic Compatibility » en anglais) doit mesurer la compatibilité électromagnétique d'un appareil ou de ses composants électroniques. Il s'agit d'une enceinte de test faradisée (ou tente de Faraday) qui est un espace clos délimité par des parois à haute conductivité électrique, ou qui sont recouverts d'une enveloppe métallique ou métallisée ayant une haute conductivité électrique.

Les différents équipements électroniques d'une automobile, d'un avion ou d'un satellite interagissent de façon électromagnétique entre eux et avec leur environnement, car ils sont perturbés par l'environnement et à leur tour ils peuvent aussi le perturber. De ce fait, il est nécessaire de vérifier leur compatibilité électromagnétique afin de garantir leur bon fonctionnement entre eux et dans un environnement électromagnétique donné, qui est souvent hostile. On réalise ainsi des essais d'immunité et d'émission en réponse à des exigences réglementaires et normatives en vigueur du domaine concerné dans une enceinte de test CEM.

Plus particulièrement, lors de ces tests, les équipements électroniques testés sont soumis à des champs électromagnétiques forts et impulsionnels sur des bandes de fréquences très larges. Ces essais peuvent être réalisés dans une enceinte de tests CEM munie de moyens de brassage mécanique et qui forme ainsi une chambre réverbérante. En effet, les champs électromagnétiques forts (de centaines ou milliers de volts) sont produits dans l'enceinte et les ondes incidentes sont soumises à des multiples réflexions réalisées par un brasseur mécanique rotatif contre les parois de l'enceinte. Le brasseur mécanique comporte des pâles métalliques fixées sur un axe entraîné en rotation. L'environnement électromagnétique ainsi créé par rotation du brasseur est statistiquement isotrope et homogène.

On connaît du document CN203643474U une chambre de tests CEM réverbérante comportant un dispositif d'agitation mécanique et un dispositif d'antenne émettrice rotative. Le dispositif d'agitation mécanique comprend un assemblage de panneaux métalliques pliés en zig-zag et supportés par l'arbre d'une structure métallique, un premier moteur d'entraînement en rotation de l'arbre et un dispositif de commande du moteur. En fonctionnement, un champ électromagnétique uniforme est obtenu dans la chambre réverbérante dû à la rotation simultanée du dispositif d'agitation mécanique et de l'antenne. Le besoin d'un dispositif d'agitation plus efficace reste présent.

On connaît également un autre type de brasseur mécanique d'ondes électromagnétiques qui est réalisé sous forme d'une structure métallique comportant un arbre central muni de plusieurs bras s'étendant radialement vers l'extérieur de l'arbre et supportant chacun des pales en un matériau réfléchissant. Les pales sont des panneaux plans pliés faisant un certain angle entre eux. Une telle structure métallique implique une masse très importante et est difficile à déplacer, surtout lorsqu'elle est de grandes dimensions (plusieurs mètres) afin de pouvoir s'adapter à des chambres de volumétrie importante. Les dispositifs de ces solutions sont lourds, non modulables et encombrants.

Un objectif de l'invention est de remédier aux inconvénients des dispositifs précités et d'apporter une solution originale pour un dispositif d'agitation ou de brassage mécanique des ondes électromagnétiques à l'intérieur d'une enceinte de tests CEM qui soit très léger, qui puisse être transporté ou déplacé aisément, dont la structure lui permette de s'adapter à des enceintes de test de différentes volumétries, pour un moindre coût.

Cet objectif est atteint avec un brasseur mécanique de champ électromagnétique pour enceinte de test de compatibilité électromagnétique comportant : un châssis formant support pour un plateau rotatif destiné à être couplé à des moyens d'entraînement en rotation de celui-ci; un mât agencé au centre du plateau rotatif ; et au moins une pale du brasseur de champ fixée sur le mât et comportant une face réfléchissante, caractérisé en ce que ladite pale comprend une ossature comprenant au moins un élément comprenant au moins une enveloppe à base de tissu et au moins un boudin gonflable agencé à l'intérieur de ladite au moins une enveloppe.

Autrement dit, l'invention propose un dispositif d'agitation ou de brassage mécanique des ondes électromagnétiques utilisé pour tester un appareil ou un équipement à l'intérieur d'une enceinte de test CEM qui comprend un mat monté sur un plateau rotatif en étant solidaire en rotation avec celui-ci, destiné à être entraîné en rotation autour de son axe longitudinal, le mât comportant au moins une pâle à face réfléchissante des ondes électromagnétiques, la pale comprenant une ossature réalisée à base d'un ou plusieurs éléments, comprenant chacun au moins un boudin gonflable agencé à l'intérieur d'une enveloppe en tissu, les différents éléments formant des chambres à air indépendantes. De préférence, un élément comprend une enveloppe fermée réalisée par l'assemblage de plusieurs morceaux de tissu entre eux, ladite enveloppe comportant une ouverture permettant d'y insérer un boudin gonflable. Les éléments ainsi constitués deviennent rigides lorsque les boudins sont gonflés. On obtient ainsi une pale en tissu qui maintient sa forme et peut tourner avec le mât lorsqu'il est entraîné en rotation, ce qui permet de mixer les ondes électromagnétiques émises par un dispositif de test situé dans l'enceinte en les envoyant vers les parois réfléchissantes de l'enceinte et créer ainsi un champ uniforme.

Par ossature on comprend un ensemble d'éléments rigides qui forment support pour d'autres constituants de la pale et qui permet par ailleurs son assemblage avec le mât. L'ossature d'une pale de l'invention comporte des premiers éléments rigides périphériques qui définissent le contour d'une pale et elle peut comporter en plus des deuxièmes éléments de renfort situés donc à l'intérieur du contour formé par les premiers en étant reliés à ceux-ci. A titre d'exemple, l'ossature d'une pale de forme polygonale comporte des premiers éléments périphériques définissant le contour du polygone, chaque élément renfermant un boudin gonflable, des deuxièmes éléments renfermant des boudins gonflables pouvant être situés à l'intérieur du polygone, notamment pour assurer la rigidité de l'ossature des pales de dimensions importantes.

L'ossature réalisée à base d'éléments en tissu renfermant des boudins faisant office de chambres à air présente l'avantage d'être très légère, de nécessiter une assez faible pression de gonflage (inférieure à 0,4bar) et donc de pouvoir prendre sa forme rapidement par gonflage, tout en permettant de faciliter la réparation ou le remplacement d'un boudin endommagé. On améliore ainsi la durée de vie du brasseur. L'ossature de la pale peut ensuite être recouverte ou enveloppée dans un tissu réfléchissant, ce qui fait que la pale dans son ensemble est très légère, et permet au brasseur la comportant d'être facilement transportable en vue de son utilisation. Ainsi, une telle pale pliée est légère et facilement transportable manuellement par un opérateur, son gonflage nécessitant seulement quelques minutes. Le brasseur la comportant peut ainsi être rapidement installé dans une enceinte de test CEM, tout en nécessitant peu d'espace de stockage. Par ailleurs, une structure plus légère de l'ensemble mat et pale permet l'utilisation d'un moteur moins puissant pour son entraînement en rotation, ce qui permet ainsi d'économiser l'énergie électrique consommée.

Une telle pale à ossature gonflable peut donc passer aisément de l'état gonflé dans lequel elle présente une envergure importante, par exemple de quelques mètres, à l'état non gonflé dans lequel elle occupe un très faible volume.

Le mât peut comprendre une enveloppe de mât en tissu et un boudin gonflable agencé à l'intérieur de l'enveloppe de mât. L'enveloppe peut être réalisée en un tissu électriquement conducteur ou en être recouverte. Ceci permet d'avoir une structure gonflable de l'ensemble formé par le mât et les pales, pour un poids encore plus réduit et un transport facilité de l'ensemble. Un tel ensemble de mât et pales à structure gonflable est extrêmement compact à l'état dégonflé, il peut être transporté dans un sac à dos et son gonflage, compte tenu de la faible pression de gonflage, prend environ 15 min, même pour une envergure de quelques mètres de l'ensemble.

Le tissu des éléments de l'ossature peut comprendre des fibres textiles synthétiques, par exemple du "DACRON" ^{®} et ledit boudin gonflable peut comprendre du polyuréthane. Ceci permet d'obtenir une ossature ayant un poids faible, tout en ayant une bonne résistance mécanique.

L'ossature de ladite pale peut avoir une forme en arche comportant au moins deux éléments en forme d'arche parallèles entre eux renfermant chacun au moins un boudin gonflable en étant reliés entre eux par au moins deux éléments formant traverse renfermant chacun au moins un boudin gonflable. Ceci permet d'obtenir une bonne rigidité d'une ossature en forme d'arche après gonflage des boudins.

Le brasseur peut comprendre au moins deux pales s'étendant radialement par rapport à l'axe central du mât et qui sont agencées sensiblement à équidistance angulaire l'une de l'autre. Par agencées sensiblement à équidistance l'une de l'autre, on comprend que les pales font entre elles un angle égal à 360° divisé par le nombre de pales avec une tolérance de +/- 20°. Ainsi, plusieurs pales uniformément réparties sur la circonférence du mât permettent un brassage amélioré du champ électromagnétique au sein de l'enceinte CEM.

Le brasseur peut comprendre au moins deux pales de formes et/ou dimensions différentes. Ceci permet d'améliorer encore plus le brassage du champ électromagnétique au sein de l'enceinte CEM.

Le mât peut avoir une forme cylindrique et la ou les pales peuvent être fixées sur la génératrice du mât par un élément de leur ossature, le mât pouvant être muni d'attaches qui viennent coopérer avec des attaches complémentaires des pales. Ceci permet d'attacher, voire, lorsque les attaches sont amovibles, de détacher les pâles au mât, tout en permettant d'obtenir une envergure importante de l'ensemble pour un brassage optimisé des ondes à l'intérieur de l'enceinte CEM.

Les attaches du mât et les attaches complémentaires des pales peuvent comprendre une ou plusieurs fermetures à glissière. Une telle fermeture à glissière ou à crémaillère ou éclair permet d'attacher et de détacher facilement les pales par rapport au mât, tout en assurant un positionnement précis entre eux des différents éléments ainsi assemblés.

L'ossature de la pale peut être recouverte d'un matériau électriquement conducteur. On peut envelopper l'ossature d'un tel matériau électriquement conducteur apte à réfléchir les ondes électromagnétiques, ou le rapporter sur l'ossature, par exemple par couture de manière définitive ou de manière détachable notamment à l'aide d'une fixation de type autoagrippante ou de type "VELCRO" ^{®}.

L'enveloppe du mât peut être solidaire d'une plaque rigide destinée à être fixée de manière démontable sur ledit plateau rotatif. Ceci permet d'utiliser un même plateau avec différents mâts, tout en rendant le mât facilement transportable. La plaque rigide fixée à la base du mât contribue à la stabilité du mât et des pales qu'il supporte.

Ledit châssis peut être supporté par des pieds qui sont déportés radialement vers l'extérieur par rapport à la plaque de support. Cette solution permet d'obtenir une bonne stabilité de l'ensemble du brasseur, malgré l'envergure importante de l'ensemble en position gonflée de celui-ci.

Lesdits pieds peuvent être munis de roulettes à leur extrémité. Ceci permet le déplacement de l'ensemble du brasseur au sein de l'enceinte de test CEM.

L'objet de l'invention est également atteint avec un procédé d'assemblage d'un brasseur mécanique de champ électromagnétique pour enceinte de test de compatibilité électromagnétique comportant : un châssis formant support pour un plateau rotatif destiné à être couplé à des moyens d'entraînement en rotation de celui-ci; un mât monté sur le plateau rotatif; et au moins une pale du brasseur de champ fixée sur le mât et comportant une face réfléchissante,
dans lequel ladite pale comprend une ossature comprenant au moins un élément comprenant au moins une enveloppe à base de tissu et au moins un boudin gonflable agencé à l'intérieur de ladite au moins une enveloppe et où le procédé comprend une étape de gonflage du ou des boudins gonflables à l'intérieur de l'ossature de ladite pale après avoir assemblé ladite pale avec le mât.

Le procédé de l'invention peut comporter une étape supplémentaire de gonflage du boudin gonflable situé à l'intérieur de l'enveloppe du mât avant sa fixation au plateau rotatif.

Le brasseur de l'invention peut comporter au moins des première et deuxième pales et où l'on procède au gonflage desdites première et deuxième pales après le gonflage du mât. Ceci permet un assemblage et une mise en forme très rapides des parties gonflables du brasseur. Ainsi on peut gonfler un mat supportant plusieurs ailes d'une envergure d'environ 4m en moins de 15min.

On peut recouvrir de tissu métallique au moins une face de la structure gonflable de ladite au moins une pâle après gonflage de celle-ci.

Le mât peut comprendre une structure gonflable et le procédé peut comprendre une étape de gonflage de la structure gonflable du mât et une étape de fixation du mât au plateau rotatif.

L'invention sera mieux comprise grâce à la suite de la description, qui s'appuie sur les figures suivantes :
la figure 1 est une en perspective d'un ensemble de brasseur selon l'invention;
la figure 2 est une vue en perspective d'un châssis de support de la structure du brasseur de l'invention ;
la figure 3 est une vue en perspective d'un bras stabilisateur du châssis de la figure 2 ;
la figure 4 est une vue en perspective d'un ensemble de brasseur de la figure 1 dans lequel on a retiré l'enveloppe des pales afin de rendre visible leur ossature;
la figure 5 est une vue similaire à celle de la figure 4 prise sous un autre angle;
la figure 6 est une vue en perspective de l'ossature d'une première pale du brasseur de la figure 1 et la figure 7 est une vue de face de la pale de la figure 6 ;
la figure 8 est une vue en perspective de l'ossature d'une deuxième pale du brasseur de la figure 1,
la figure 9 est une vue de dessous de la même pâle et la figure 10 est une vue de face de la pale des figures 8 et 9;
la figure 11 est une vue en perspective de l'ossature d'une troisième pale du brasseur de la figure 1 et la figure 12 est une vue de face de la pale de la figure 11 ;
la figure 13 est une vue en perspective de l'ossature d'une quatrième pale du brasseur de la figure 1,
la figure 14 est une vue de dessous de la même pâle
et la figure 15 est une vue de face de la pale des figures 13 et 14.

Sur les différentes figures, les éléments identiques ou similaires portent la même référence. Leur description n'est donc pas systématiquement reprise.

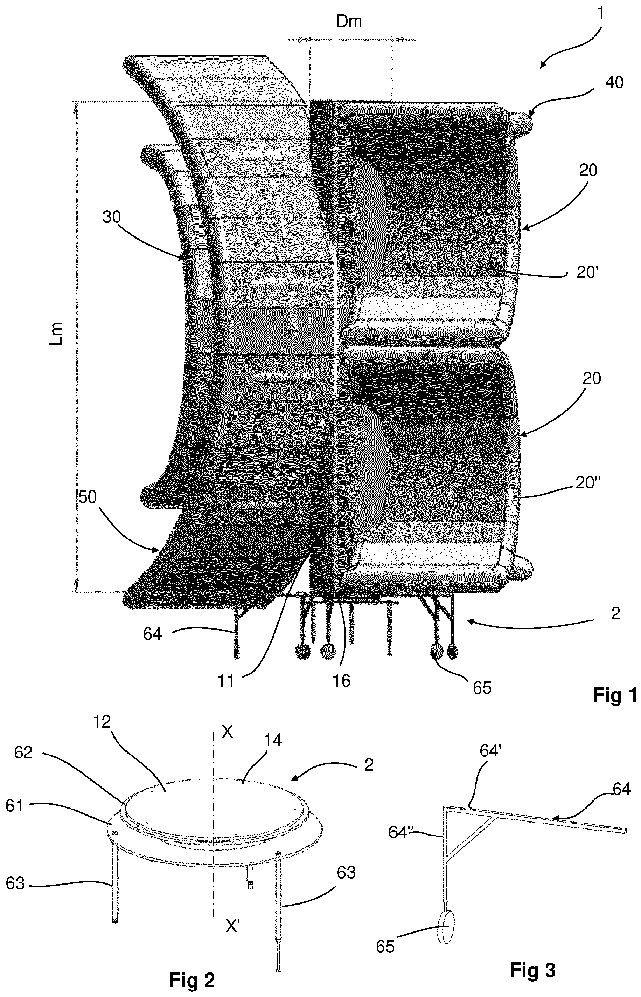

La figure 1 illustre un brasseur 1 mécanique d'ondes électromagnétiques de l'invention. Il est destiné à être installé dans une enceinte de test CEM. Toutes les parois, ainsi que le sol et le plafond d'une telle enceinte de test sont en un matériau métallique ou métallisé ou elles en sont recouvertes. Une telle enceinte peut être réalisée à base d'une structure gonflable recouverte d'un tissu métallisé appelé aussi tissu faradisé. A l'intérieur de l'enceinte CEM on installe l'appareil à tester et des moyens permettant d'effectuer les tests, telle une antenne émettrice reliée à un générateur de champ, installé lui, à l'extérieur de l'enceinte. Un brasseur mécanique du champ électromagnétique produit est disposé proche de l'antenne émettrice, de manière à pouvoir, lors de sa rotation, intercepter et envoyer les ondes contre les parois de l'enceinte afin de les mélanger et d'homogénéiser ainsi le champ électromagnétique dans l'enceinte de test formant une chambre réverbérante.

Tel que visible à la figure 1, le brasseur 1 comprend un châssis 2 comportant une plaque de support 61 pour un plateau rotatif 62 destiné à être couplé à des moyens d'entraînement en rotation de celui-ci (non illustrés sur la figure) autour d'un axe central X-X' du plateau, perpendiculaire au plan de celui-ci. Dans la variante de la figure 2, la plaque de support 61 comprend trois tiges 63 de support, de hauteur réglable, par exemple moyennant une tige filetée qui se déplace à l'intérieur d'un fut fileté qui est monté, lui, fixe sur la face inférieure de la plaque 61. Dans un mode préféré de réalisation de l'invention, on rajoute à la plaque de support 61 plusieurs pieds 64 réalisés de manière à être déportés radialement par rapport au pourtour de la plaque de support 61. Chaque pied 64 comprend un bras horizontal 64' relié, à l'une de ses extrémités, à la plaque 61 et, à l'extrémité opposée, à une tige verticale 64" qui prend appui au sol moyennant une roulette 65. Par pied déporté radialement, on comprend que l'extrémité du pied portant la tige verticale fait saillie radialement par rapport à la périphérie de la plaque 61. Dans un mode préféré de réalisation, le pied 4 est déporté radialement d'une distance au moins égale au rayon de la plaque 61, cinq pieds 64 étant ainsi disposés à égale distance entre eux sur le pourtour de la plaque 61. Ces pieds 64 ont pour rôle de stabiliser l'ensemble du brasseur. La tige verticale 64" peut également être réglable en hauteur en étant réalisée de la même manière que la tige 63. La roulette 65 est libre en rotation et permet un déplacement facilité du châssis 2, et donc de l'ensemble du brasseur à l'intérieur de l'enceinte de test.

Le plateau rotatif 62 est porté par la plaque de support 61 moyennant des roulements (non illustrés) et comprend en sa partie inférieure (on comprend la partie opposée à celle supérieure de réception du mât du brasseur) un élément de couplage avec l'axe de sortie d'un moteur électrique d'entraînement en rotation. Un tel moteur est de préférence un moteur électrique pas-à-pas, alimenté par une batterie électrique, et piloté à distance via une électronique de contrôle. Le moteur, la batterie électrique d'alimentation et l'électronique de contrôle sont contenus dans un boîtier métallique et disposé sous la plaque de support 61 du châssis 2.

Tel que visible à la figure 1, le brasseur mécanique 1 comprend un mât 11 de support d'au moins une pale 20 ayant une face réfléchissante des ondes électromagnétiques, de préférence les deux faces intrados 20' et extrados 20" étant réfléchissantes, le mât est agencé au centre du plateau rotatif 62 et est rendu solidaire en rotation de celui-ci. Plus particulièrement selon l'invention, ladite au moins une pale 20 comprend une ossature 21 composée d'éléments réalisés à base de tissu renfermant chacun au moins un boudin gonflable. Dans un mode préféré de réalisation de l'invention et illustré aux figures, le brasseur 1 comprend plusieurs pales, dont deux pales identiques 20, une pale 30, une pale 40 et une pale 50 ayant des dimensions et des formes différentes, tel qu'il sera expliqué par la suite.

Dans l'exemple illustré aux figures, le mât 11 présente également une ossature gonflable. Il comprend une enveloppe de mât 16 cylindrique gonflable en un matériau souple, l'enveloppe étant fermée aux deux extrémités. L'une des extrémités qui forme la base du mât comprend une plaque rigide 12 de forme circulaire (fig. 2) destinée à être fixée au plateau rotatif 62, par exemple à l'aide des vis. La figure 2 montre le plateau rigide 2 fixé au plateau rotatif 62 à l'aide de plusieurs vis 14, l'enveloppe de mât 16 (non illustrée à la fig. 2) étant refermée sur le plateau rigide 12. L'enveloppe de mât 16 est réalisée dans un tissu électriquement conducteur, ou en un tissu synthétique de type "DACRON" ^{®} recouvert d'un tissu électriquement conducteur. L'enveloppe de mât 16 renferme un boudin gonflable en polyuréthane, le boudin étant muni d'une valve permettant son gonflage, respectivement son dégonflage. Lorsqu'il est gonflé, le boudin situé à l'intérieur de l'enveloppe du mât se déploie entre l'extrémité supérieure du mât et le plateau rigide 12 permettant la mise en forme du mât 11. A titre d'exemple, le diamètre du mât Dm est d'environ 0,7m pour une hauteur Hm d'environ 4,2m.

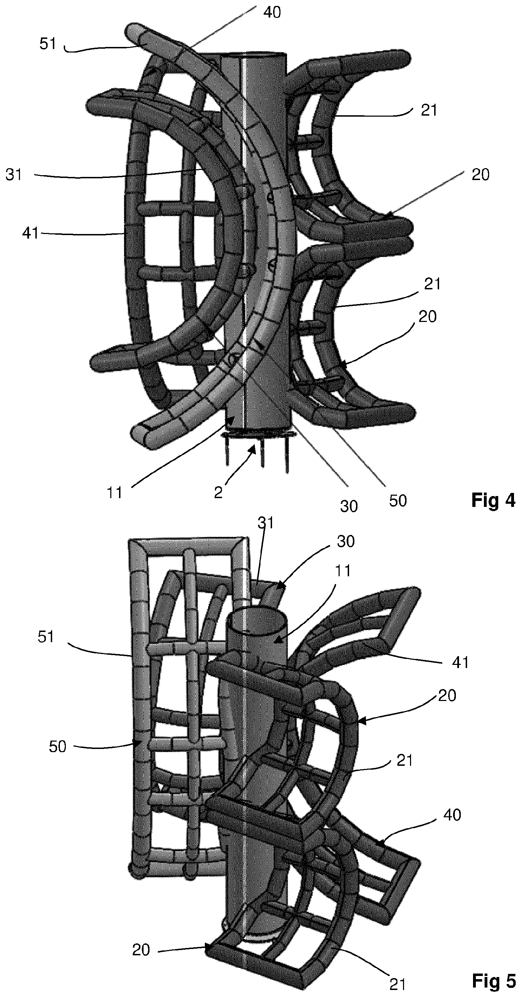

Chaque pale 20, 30, 40, 50 du brasseur 1 de l'invention comprend une ossature gonflable comportant au moins deux arches parallèles en étant reliées entre elles par plusieurs traverses. L'ossature des pales du brasseur est mieux visible aux figures 4 et 5 dans lesquelles l'enveloppe extérieure des pales a été retirée. Ainsi, le brasseur 1 comprend trois groupes de pales répartis sur la circonférence du mât 11. Un premier groupe est formé par deux pales 20 en forme d'arche agencées l'une dans le prolongement de l'autre sur une même première génératrice du mât 11. Un deuxième groupe est formé par deux autres pâles 30 et 50 en forme d'arche agencées de manière sensiblement concentrique de part et d'autre d'une deuxième génératrice formant 120° avec la première génératrice. Un troisième groupe comprend une seule pale 40 agencée sur une troisième génératrice du mât 11 située à 120° de la deuxième et de la première génératrice du mât.

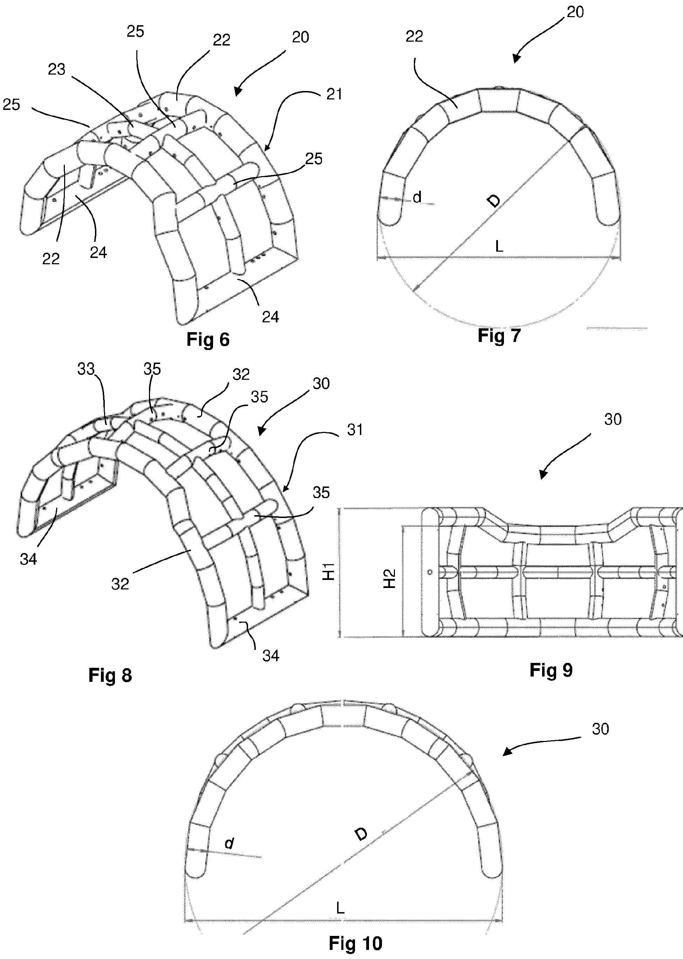

Les figures 6 et 7 illustrent différentes vues de l'ossature 21 d'une pale 20. L'ossature est 21 formée de deux arches périphériques 22, une arche intermédiaire 23, deux côtés 24 reliant la base des arches et trois traverses 25 reliant les arches 22 et 23 entre elles à différents niveaux à partir de leurs bases. L'arche périphérique 22 et l'arche intermédiaire 23 sont formées chacune de plusieurs morceaux de tissu cousus entre eux (les coutures étant visibles sous forme de traits transversaux dans les figures) pour former une arche en tissu à l'intérieur de laquelle on introduit un boudin gonflable muni d'une valve de gonflage. De manière similaire, les côtés 24, ainsi que les traverses 25, sont obtenus chacun et chacune par couture de morceaux de tissus pour former un côté de forme cylindrique à l'intérieur duquel on introduit un boudin gonflable muni d'une valve de gonflage. On fait ensuite avantageusement communiquer entre eux les différents boudins gonflables (par exemple à l'aide de tuyaux de liaison externes étanches) afin de faciliter le gonflage de l'ensemble de l'ossature 21 à partir d'une seule valve de gonflage. Un boudin gonflable est un tube cylindrique fermé, en polyuréthane, dont les dimensions sont sensiblement celles de l'enveloppe dans laquelle il est inséré. L'ossature ainsi réalisée est définie par son diamètre extérieur D, sa largeur L et le diamètre d de l'arche 23. A titre d'exemple, l'ossature 21 présente un diamètre D d'environ 2m, une largeur L d'environ 2m et un diamètre d externe de l'arche d'environ 0,2m. Le diamètre externe des côtés 24 est sensiblement égal au diamètre externe d de l'arche périphérique 22. Les diamètres externes des traverses 25 et des arches intermédiaires 23 sont, eux, inférieurs au diamètre externe de l'arche périphérique 22. De manière similaire à l'ossature de la figure 9 qui sera décrite dans ce qui suit, l'arche principale 23 est aplatie au niveau de sa fixation à la génératrice du mât sur une partie de la longueur de l'arche comprise entre les deux dernières traverses 25, la longueur H1 du côté 24 étant d'environ 1,4m et la longueur H2 de la partie aplatie étant d'environ 1,2m.

Les figures 8 à 10 illustrent différentes vues de l'ossature 31 d'une pale 30. L'ossature 31 est formée de deux arches périphériques 32, une arche intermédiaire 33, deux côtés 34 reliant la base des arches et quatre traverses 35 reliant les arches 32 et 33 entre elles à différents niveaux à partir de leurs bases. Les éléments de l'ossature 31, notamment les arches, les côtés et les traverses sont réalisées de manière similaire à ceux de la pale 20, tel que déjà décrit. On note plus particulièrement en référence à la figure 9 que l'une des arches principales 33 qui est destinée à la fixation sur la génératrice du mât 11 est aplatie sur une partie de sa longueur comprise entre les deux dernières traverses 35, correspondant à la côte H2 sur la figure 9 égale à environ1,2m, pour une longueur du côté H1 de l'arche d'environ 1,4m. A titre d'exemple, l'ossature 31 présente un diamètre D d'environ 3,1m, une largeur L d'environ 3,1m et un diamètre d de l'arche d'environ 0,2m.

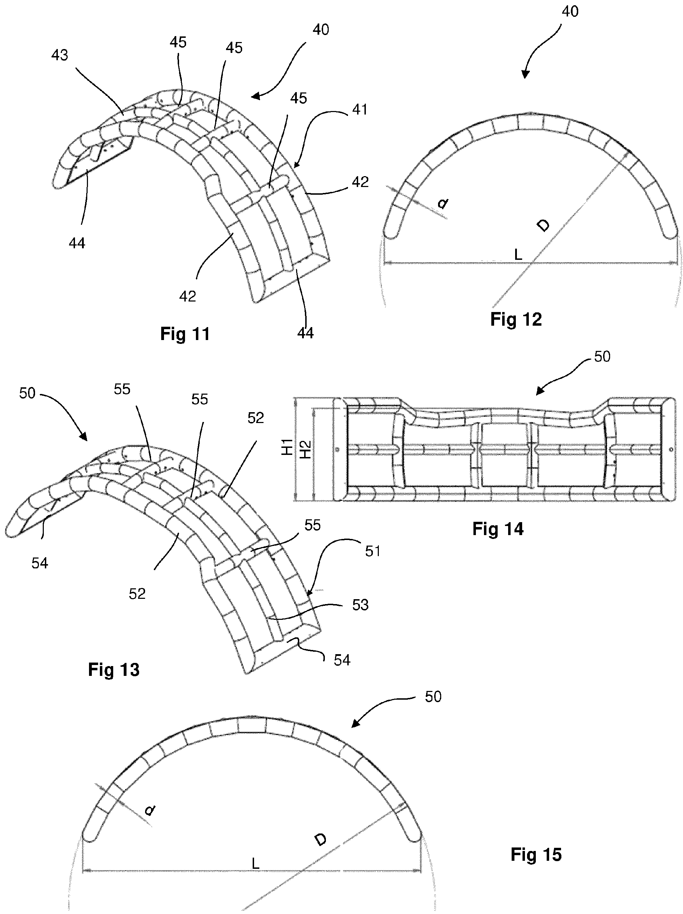

Les figures 11 à 12 illustrent différentes vues de l'ossature 41 d'une pale 40 similaire à celles déjà décrites. L'ossature 41 est formée de deux arches périphériques 42, une arche intermédiaire 43, deux côtés 44 reliant la base des arches et quatre traverses 45 reliant les arches 42 et 43 entre elles à différents niveaux à partir de leurs bases. Les éléments de l'ossature 41, notamment les arches, les côtés et les traverses sont réalisés de manière similaire à ceux de la pale 20, tel que déjà décrit. On note également, comme précédemment décrit, que l'une des arches principales 43 qui est destinée à la fixation sur la génératrice du mât 11 est aplatie sur une longueur de l'arche comprise entre les deux dernières traverses 45, correspondant à la côte H2 de la figure 9 égale à environ1,2m pour une longueur du côté H1 de l'arche d'environ 1,4m. A titre d'exemple, l'ossature 41 présente un diamètre D d'environ 4,1m, une largeur L d'environ 3,9m et un diamètre d de l'arche d'environ 0,2m.

Les figures 13 à 15 illustrent différentes vues de l'ossature 51 d'une pale 50 elle aussi similaire aux précédentes. L'ossature 51 est formée de deux arches périphériques 52, une arche intermédiaire 53, deux côtés 54 reliant la base des arches et quatre traverses 55 reliant les arches 52 et 53 entre elles à différents niveaux à partir de leurs bases. Les éléments de l'ossature 51, notamment les arches, les côtés et les traverses sont réalisés de manière similaire à ceux de la pale 20, tel que déjà décrit. On note plus particulièrement en référence à la figure 14 que l'une des arches principales 53 qui est destinée à la fixation sur la génératrice du mât 11 est aplatie sur environ une partie de sa longueur comprise entre les deux dernières traverses 55, correspondant à la côte H2 sur la figure 14 égale à environ 1,2m, pour une longueur du côté H1 de l'arche d'environ 1,4m. A titre d'exemple, l'ossature 31 présente un diamètre D d'environ 5,1m, une largeur L d'environ 4,6m et un diamètre d de l'arche d'environ 0,2m.

L'enveloppe des éléments de l'ossature 21, 31, 41, 51, est réalisée dans un tissu synthétique de type "DACRON" ^{®}. L'enveloppe de chaque élément est fermée et réalisée par couture de plusieurs morceaux de tissu entre eux, et dans celle-ci a été aménagée une ouverture permettant d'y insérer un boudin gonflable.

L'ossature de chaque pale est recouverte d'un tissu électriquement conducteur. De manière avantageuse, le tissu est rapporté à l'aide de bandes autoagrippantes ou de type "VELCRO" ^{®}, une partie des bandes étant cousue sur l'ossature et une autre sur le tissu de recouvrement de la pale.

Les pales ainsi obtenues sont très légères. Elles sont uniformément réparties sur la circonférence du mât qui, lui, est déjà lesté par la plaque rigide qui le fixe au plateau rotatif et donc au châssis lui assurant une bonne stabilité. Ainsi, lorsque l'on rajoute à ce mât des pales légères, bien réparties sur le pourtour du mât, on obtient une bonne stabilité de l'ensemble. La stabilité est de surcroît renforcée à l'aide des pieds déportés radialement vers l'extérieur du plateau rotatif, ce qui assure une bonne uniformité lors de la rotation du brasseur autour de l'axe longitudinal vertical du mât.

Selon un mode avantageux de réalisation de l'invention, l'assemblage entre le mât 11 et les pales 20, 30, 40, 50 se fait à l'aide de fermetures à glissière (ou fermetures éclair). Pour ce faire, une partie de la fermeture éclair est cousue sur la génératrice du mât et la partie correspondante est cousue sur l'une des arches de la pale en vis-à-vis.

Le stockage des différentes parties comportant des éléments renfermant des boudins gonflables est fait à l'état dégonflé, les pales étant détachées du mât pour faciliter le stockage et le transport, surtout dans le cas de pales de grandes dimensions.

Lorsque l'on veut mettre en fonctionnement le brasseur, on commence par assembler les pales et le mât à l'aide des fermetures à glissière. Une fois l'assemblage réalisé, on commence par gonfler une pale, puis le mât, puis le reste des pales avec le mat positionné et fixé sur son châssis. La pression de gonflage des boudins gonflables à l'intérieur du mât et des pales est d'environ 0,2 à 0,35 bar.

En fonctionnement, le plateau rotatif 62 reçoit le mouvement de rotation en provenance de moyens d'entraînement en rotation qui sont enfermés dans un boîtier métallique et comprennent un moteur pas-à-pas alimenté par une batterie et des moyens de contrôle de celui-ci. On met ainsi en rotation le brasseur selon un protocole de commande établi et on obtient, au bout d'un intervalle de temps déterminé, un champs électromagnétique homogène et isotrope dans tout le volume interne de l'enceinte de test CEM.

Dans une variante, les pales 20 peuvent être agencées l'une dans le prolongement de l'autre sur le mât 11, mais en faisant subir une rotation de 180° à l'une des pales 20 par rapport à l'autre et obtenir ainsi une pale en forme de S. Plusieurs pales en S peuvent être disposées sur le mât 11.

Dans une autre variante, les pales 20 sont planes, de forme polygonale, par exemple rectangulaire.

D'autres variantes et modes de réalisation de l'invention peuvent être envisagés dans le cadre de l'invention telle que revendiquée. Ainsi, les pales du brasseur peuvent avoir une forme de portion de sphère ou de portion de parabole, ou toute autre forme incurvée. Par ailleurs, le mât 11 peut avoir une forme de prisme droit, afin d'offrir une face plane de fixation aux pales du brasseur. Dans une variante le mât est rigide, il est de préférence télescopique.

Par ailleurs, on peut envisager de réaliser un brasseur de plus petite taille qui s'introduit à l'intérieur d'un appareil pour rendre le champ électromagnétique homogène en vue des mesures de CEM à l'intérieur de celui-ci.

## Revendications

1. Brasseur (1) mécanique de champ électromagnétique pour enceinte de test de compatibilité électromagnétique comportant :
un châssis (2) formant support pour un plateau rotatif (62) destiné à être couplé à des moyens d'entraînement en rotation de celui-ci;
un mât (11) monté sur le plateau rotatif (62); et
au moins une pale (20, 30, 40, 50) du brasseur de champ fixée sur le mât et comportant une face réfléchissante, **caractérisé en ce que** ladite pale (20, 30, 40, 50) comprend une ossature (21, 31, 41, 51) comprenant au moins un élément comprenant au moins une enveloppe à base de tissu et au moins un boudin gonflable agencé à l'intérieur de ladite au moins une enveloppe.

2. Brasseur selon la revendication 1, **caractérisé en ce que** ledit mât (11) comprend une enveloppe de mât en tissu et un boudin gonflable agencé à l'intérieur de l'enveloppe de mât.

3. Brasseur selon l'une des revendications 1 ou 2, **caractérisé en ce que** ledit tissu comprend des fibres textiles synthétiques et ledit boudin gonflable comprend du polyuréthane.

4. Brasseur selon l'une des revendications précédentes, **caractérisé en ce que** l'ossature (21, 31, 41, 51) de ladite pale (20, 30, 40, 50) a une forme en arche comportant au moins deux éléments en forme d'arche parallèles entre eux renfermant chacun au moins un boudin gonflable en étant reliés entre eux par au moins deux éléments formant traverse renfermant chacun au moins un boudin gonflable.

5. Brasseur selon l'une des revendications précédentes, **caractérisé en ce qu'**il comprend au moins deux pales (20, 30, 40, 50) s'étendant radialement par rapport à l'axe central du mât (11) et étant agencées sensiblement à équidistance angulaire l'une de l'autre.

6. Brasseur selon l'une des revendications précédentes, **caractérisé en ce qu'**il comprend au moins deux pales (20, 30, 40, 50) de formes et/ou dimensions différentes.

7. Brasseur selon l'une des revendications précédentes, **caractérisé en ce que** ledit mât (11) a une forme cylindrique et que la ou les pales (20, 30, 40, 50) sont fixées sur la génératrice du mât (11) par un élément de leur ossature (21, 31, 41, 51), le mât étant muni d'attaches qui viennent coopérer avec des attaches complémentaires des pales.

8. Brasseur selon la revendication précédente **caractérisé en ce que** les attaches du mât (11) et les attaches complémentaires de ladite au moins une pale (20, 30, 40, 50) comprennent une ou plusieurs fermetures à glissière.

9. Brasseur selon l'une des revendications précédentes, **caractérisé en ce que** l'ossature (21, 31, 41, 51) de ladite au moins une pale (20, 30, 40, 50) est recouverte d'un matériau électriquement conducteur.

10. Brasseur selon la revendication 2 ou l'une des revendications 3 à 9 prise en combinaison avec la revendication 2, **caractérisé en ce que** l'enveloppe du mât (11) est solidaire d'une plaque rigide (12) destinée à être fixée de manière démontable sur ledit plateau rotatif (62).

11. Brasseur selon l'une des revendications précédentes, **caractérisé en ce que** ledit châssis (2) est supporté par des pieds (64) qui sont déportés radialement vers l'extérieur par rapport à la plaque de support.

12. Brasseur selon la revendication précédente, **caractérisé en ce que** lesdits pieds (64) sont munis de roulettes (65) à leur extrémité.

13. Procédé d'assemblage d'un brasseur (1) mécanique de champ électromagnétique pour enceinte de test de compatibilité électromagnétique comportant :
un châssis (2) formant support pour un plateau rotatif (62) destiné à être couplé à des moyens d'entraînement en rotation de celui-ci;
un mât (11) monté sur le plateau rotatif (62); et au moins une pale (20, 30, 40, 50) du brasseur de champ fixée sur le mât (11) et comportant une face réfléchissante, dans lequel ladite pale (20, 30, 40, 50) comprend une ossature (21, 31, 41, 51) comprenant au moins un élément comprenant au moins une enveloppe à base de tissu et au moins un boudin gonflable agencé à l'intérieur de ladite au moins une enveloppe et où le procédé comprend une étape de gonflage du ou des boudins gonflables à l'intérieur de l'ossature de ladite pale après avoir assemblé ladite pale avec le mât.

14. Procédé d'assemblage d'un brasseur selon la revendication précédente, dans lequel ledit mât (11) comprend une enveloppe de mât qui renferme un boudin gonflable, **caractérisé en ce qu'**il comprend une étape de gonflage du boudin gonflable situé à l'intérieur de l'enveloppe du mât avant sa fixation au plateau rotatif.

15. Procédé selon la revendication précédente, dans lequel le brasseur comporte au moins des première et deuxième pales et où l'on procède au gonflage desdites première et deuxième pales.

## Patentansprüche

1. Mechanischer Elektromagnetfeld-Rührer (1) für eine Prüfkammer für elektromagnetische Verträglichkeit, welcher aufweist:
ein Gestell (2), das einen Träger für eine Drehplatte (62) bildet, die dazu bestimmt ist, mit Mitteln zum Drehantrieb derselben gekoppelt zu werden;
einen Mast (11), der auf der Drehplatte (62) angebracht ist; und
mindestens einen Flügel (20, 30, 40, 50) des Feldrührers, der an dem Mast befestigt ist und eine reflektierende Fläche aufweist, **dadurch gekennzeichnet, dass** der Flügel (20, 30, 40, 50) ein Gerüst (21, 31, 41, 51) umfasst, das mindestens ein Element umfasst, das mindestens eine Hülle auf Gewebebasis und mindestens einen aufblasbaren Wulst, der im Inneren der mindestens einen Hülle angeordnet ist, umfasst.

2. Rührer nach Anspruch 1, **dadurch gekennzeichnet, dass** der Mast (11) eine Masthülle aus Gewebe und einen aufblasbaren Wulst, der im Inneren der Masthülle angeordnet ist, umfasst.

3. Rührer nach einem der Ansprüche 1 oder 2, **dadurch gekennzeichnet, dass** das Gewebe synthetische Textilfasern umfasst und der aufblasbare Wulst Polyurethan umfasst.

4. Rührer nach einem der vorhergehenden Ansprüche, **dadurch gekennzeichnet, dass** das Gerüst (21, 31, 41, 51) des Flügels (20, 30, 40, 50) eine Bogenform aufweist, die mindestens zwei zueinander parallele bogenförmige Elemente aufweist, die jeweils mindestens einen aufblasbaren Wulst umschließen, wobei sie miteinander durch mindestens zwei Elemente, die Querstreben bilden, verbunden sind, die jeweils mindestens einen aufblasbaren Wulst umschließen.

5. Rührer nach einem der vorhergehenden Ansprüche, **dadurch gekennzeichnet, dass** er mindestens zwei Flügel (20, 30, 40, 50) umfasst, die sich radial bezüglich der Mittelachse des Mastes (11) erstrecken und im Wesentlichen in gleichen Winkelabständen voneinander angeordnet sind.

6. Rührer nach einem der vorhergehenden Ansprüche, **dadurch gekennzeichnet, dass** er mindestens zwei Flügel (20, 30, 40, 50) mit unterschiedlichen Formen und/oder Abmessungen umfasst.

7. Rührer nach einem der vorhergehenden Ansprüche, **dadurch gekennzeichnet, dass** der Mast (11) eine zylindrische Form aufweist und dass der oder die Flügel (20, 30, 40, 50) an der Erzeugenden des Mastes (11) durch ein Element ihres Gerüsts (21, 31, 41, 51) befestigt sind, wobei der Mast mit Verbindungselementen versehen ist, die mit komplementären Verbindungselementen der Flügel zusammenwirken.

8. Rührer nach dem vorhergehenden Anspruch, **dadurch gekennzeichnet, dass** die Verbindungselemente des Mastes (11) und die komplementären Verbindungselemente des mindestens einen Flügels (20, 30, 40, 50) einen oder mehrere Reißverschlüsse umfassen.

9. Rührer nach einem der vorhergehenden Ansprüche, **dadurch gekennzeichnet, dass** das Gerüst (21, 31, 41, 51) des mindestens einen Flügels (20, 30, 40, 50) mit einem elektrisch leitenden Material bedeckt ist.

10. Rührer nach Anspruch 2 oder nach einem der Ansprüche 3 bis 9 in Verbindung mit Anspruch 2, **dadurch gekennzeichnet, dass** die Hülle des Mastes (11) mit einer starren Platte (12) fest verbunden ist, die dazu bestimmt ist, lösbar auf der Drehplatte (62) befestigt zu werden.

11. Rührer nach einem der vorhergehenden Ansprüche, **dadurch gekennzeichnet, dass** das Gestell (2) von Beinen (64) gestützt wird, die bezüglich der Stützplatte radial nach außen verlagert sind.

12. Rührer nach dem vorhergehenden Anspruch, **dadurch gekennzeichnet, dass** die Beine (64) an ihrem Ende mit Röllchen (65) ausgestattet sind.

13. Verfahren zum Zusammenbau eines mechanischen Elektromagnetfeld-Rührers (1) für eine Prüfkammer für elektromagnetische Verträglichkeit, umfassend:
ein Gestell (2), das einen Träger für eine Drehplatte (62) bildet, die dazu bestimmt ist, mit Mitteln zum Drehantrieb derselben gekoppelt zu werden;
einen Mast (11), der auf der Drehplatte (62) angebracht ist; und
mindestens einen Flügel (20, 30, 40, 50) des Feldrührers, der an dem Mast (11) befestigt ist und eine reflektierende Fläche aufweist, wobei der Flügel (20, 30, 40, 50) ein Gerüst (21, 31, 41, 51) umfasst, das mindestens ein Element umfasst, das mindestens eine Hülle auf Gewebebasis und mindestens einen aufblasbaren Wulst, der im Inneren der mindestens einen Hülle angeordnet ist, umfasst, und wobei das Verfahren einen Schritt des Aufblasens des oder der aufblasbaren Wülste im Inneren des Gerüsts des Flügels umfasst, nachdem der Flügel mit dem Mast zusammengebaut worden ist.

14. Verfahren zum Zusammenbau eines Rührers nach dem vorhergehenden Anspruch, wobei der Mast (11) eine Masthülle umfasst, die einen aufblasbaren Wulst umschließt, **dadurch gekennzeichnet, dass** es einen Schritt des Aufblasens des aufblasbaren Wulstes, der sich im Inneren der Masthülle befindet, vor seiner Befestigung an der Drehplatte umfasst.

15. Verfahren nach dem vorhergehenden Anspruch, wobei der Rührer mindestens einen ersten und einen zweiten Flügel umfasst und wobei das Aufblasen des ersten und des zweiten Flügels vorgenommen wird.

## Claims

1. Mechanical electromagnetic field stirrer (1) for an electromagnetic compatibility test enclosure comprising:
a chassis (2) forming a support for a turntable (62) suitable for being coupled to means for rotating said turntable;
a mast (11) mounted on the turntable (62);
and
at least one blade (20, 30, 40, 50) of the field stirrer fastened to the mast and comprising a reflective face, **characterized in that** said blade (20, 30, 40, 50) comprises a framework (21, 31, 41, 51) comprising at least one element comprising at least one fabric-based envelope and at least one inflatable tube arranged inside said at least one envelope.

2. Stirrer according to Claim 1, **characterized in that** said mast (11) comprises a fabric mast envelope and an inflatable tube arranged inside the mast envelope.

3. Stirrer according to one of Claims 1 and 2, **characterized in that** said fabric comprises synthetic textile fibres and said inflatable tube comprises polyurethane.

4. Stirrer according to one of the preceding claims, **characterized in that** the framework (21, 31, 41, 51) of said blade (20, 30, 40, 50) is in the shape of an arch comprising at least two parallel arch-shaped elements each containing at least one inflatable tube and connected to each other by at least two elements forming crossmembers, each containing at least one inflatable tube.

5. Stirrer according to one of the preceding claims, **characterized in that** it comprises at least two blades (20, 30, 40, 50) extending radially relative to the central axis of the mast (11) and arranged substantially angularly equidistant from each other.

6. Stirrer according to one of the preceding claims, **characterized in that** it comprises at least two blades (20, 30, 40, 50) having different shapes and/or dimensions.

7. Stirrer according to one of the preceding claims, **characterized in that** said mast (11) has a cylindrical shape and the blade(s) (20, 30, 40, 50) is/are fastened to the generatrix of the mast (11) by an element of their framework (21, 31, 41, 51), the mast being provided with fasteners that interact with complementary fasteners on the blades.

8. Stirrer according to the preceding claim, **characterized in that** the fasteners on the mast (11) and the complementary fasteners on said at least one blade (20, 30, 40, 50) comprise one or more sliding fasteners.

9. Stirrer according to one of the preceding claims, **characterized in that** the framework (21, 31, 41, 51) of said at least one blade (20, 30, 40, 50) is covered in an electrically conductive material.

10. Stirrer according to Claim 2 or one of Claims 3 to 9 taken in combination with Claim 2, **characterized in that** the envelope of the mast (11) is rigidly connected to a rigid plate (12) suitable for being removably fastened to said turntable (62).

11. Stirrer according to one of the preceding claims, **characterized in that** said chassis (2) is supported by feet (64) that are radially offset outwards relative to the supporting plate.

12. Stirrer according to the preceding claim, **characterized in that** the ends of said feet (64) are provided with casters (65).

13. Method for assembling a mechanical electromagnetic field stirrer (1) for an electromagnetic compatibility test enclosure comprising:
a chassis (2) forming a support for a turntable (62) suitable for being coupled to means for rotating said turntable;
a mast (11) mounted on the turntable (62); and
and at least one blade (20, 30, 40, 50) of the field stirrer fastened to the mast (11) and comprising a reflective face,
wherein said blade (20, 30, 40, 50) comprises a framework (21, 31, 41, 51) comprising at least one element comprising at least one fabric-based envelope and at least one inflatable tube arranged inside said at least one envelope and wherein the method comprises a step of inflating the inflatable tube(s) inside the framework of said blade after having assembled said blade on the mast.

14. Method for assembling a stirrer according to the preceding claim, wherein said mast (11) comprises a mast envelope that contains an inflatable tube, **characterized in that** it comprises a step of inflating the inflatable tube situated inside the envelope of the mast before it is fastened to the turntable.

15. Method according to the preceding claim, wherein the stirrer comprises at least first and second blades and said first and second blades are inflated.
